# EUROPÄISCHE PATENTANMELDUNG

(11) **EP 2 336 823 A1**
(43) Veröffentlichungstag der Anmeldung: **22.06.2011**
(21) Anmeldenummer: 09405228.9
(22) Anmeldetag: 18.12.2009
(51) Int. Cl.: G03F 1/08, G03F 1/14, B23K 26/00, B23K 26/06, C03C 23/00

(54) **Verfahren und Vorrichtung zur Herstellung von Masken für eine Laseranlage zur Erzeugung von Mikrostrukturen.**

(71) Anmelder: Boegli-Gravures S.A., CH-2074 Marin (CH)
(72) Erfinder: Boegli, Charles, 2074 Marin (CH); Weissmantel, Steffen, 09117 Chemnitz (DE); Reisse, Günter, 09117 Chemnitz (DE); Engel, Andy, 04680 Colditz (DE); Boettcher, Rene, 09648 Mittweida (DE); Steffen, Werner, 6362 Stansstad (CH)
(74) Vertreter: AMMANN PATENTANWÄLTE AG BERN

(57) **Zusammenfassung**

Beim Verfahren zur Herstellung von Masken und/oder Blenden für eine Laseranlage zur Erzeugung von Mikrostrukturen auf einer Festkörperoberfläche mittels Maskenprojektionstechnik werden im Masken und/oder Blenden-Substrat vorgegebene, die Laserstrahlung streuende, opake Flächenbereiche durch Aufrauen und Modifizieren desselben mittels eines Femtosekunden-, Pikosekunden- oder Fluor-Laserstrahls erzeugt.

Solche Masken und Blenden weisen eine stark verbesserte Lebensdauer und Präzision auf und können beispielsweise zur Herstellung von Blaze-Gitter dienen, die, in Beugungsgitter-Arrays auf einer Festkörperoberfläche angeordnet, der Erzeugung von Spektalfarben und von Mischfarben hoher Brillanz dienen.

## Beschreibung

Die vorliegende Erfindung bezieht sich auf ein Verfahren und Vorrichtung zur Herstellung von Masken und/oder Blenden für eine Laseranlage zur Erzeugung von Mikrostrukturen gemäss Oberbegriff von Patentanspruch 1 und 14. Der Einfachheit halber werden im Folgenden nur Masken erwähnt, die hier jedoch Blenden mitumfassen.

Mikrostrukturen werden in bestimmten Laseranlagen mittels Maskenprojektion erzeugt, wie z.B. in der WO 2007/012215 desselben Anmelders offenbart. Beim Laser kann es sich z.B. um einen KrF-Excimerlaser mit einer Wellenlänge von 248 Nanometer (nm) handeln. Das Maskenprojektionsverfahren mit solchen Lasern benötigt eine Masken- und Blendenkombination, die in einer Wechseleinrichtung angeordnet sein kann.

Eine Maske dient dazu, ein vorgegebenes Intensitätsprofil des Laserstrahls zu formen und den Laserstrahl somit nur an bestimmten Maskenflächenbereichen zu transmittieren. Sie ist deshalb bei Bestrahlung mit einem Hochleistungslaser einer hohen Belastung ausgesetzt, die zu Formänderungen und einem hohen Verschleiss führen kann. Um zu verhindern, dass Laserstrahlung die nicht transmittierenden Maskenflächenbereiche durchdringt, gibt es folgende Möglichkeiten: Absorption, Reflektion oder Streuung.

Für die erste Möglichkeit kann eine Lackschicht an diesen Stellen aufgetragen werden, doch hält diese der Belastung nicht lange stand. Dies gilt auch für die optische Lithographie. Für die zweite Möglichkeit kann an den gewünschten Stellen beispielsweise ein dielektrischer Spiegel abgeschieden werden. Dieses Verfahren ist jedoch sehr aufwendig. Zur Erzeugung von streuenden Bereichen sind im bekannten Stand der Technik nur Ätzverfahren bekannt, die jedoch viel zu ungenau sind. Die oben genannten Nachteile gelten umsomehr, falls Masken zur Herstellung beipielsweise von optisch wirkenden Beugungsgittern und dergleichen Mikrostrukturen dienen.

Es ist daraus folgend eine erste Aufgabe der Erfindung ein Verfahren und eine Vorrichtung zur Herstellung von Masken und Blenden anzugeben, die sehr verschleissresistent, formstabil und in Laseranlagen zur Erzeugung von Mikrostrukturen verwendbar sind. Diese Aufgabe wird mit dem Verfahren gemäss Patentanspruch 1 und der Vorrichtung gemäss Patentanspruch 14 gelöst.

Masken und Blenden, die nach dem Verfahren gemäss Patentanspruch 1 hergestellt werden, sind besonders für die Herstellung von optisch wirkenden Beugungsgittern geeignet, die der Erzeugung von Spektralfarben mit hoher Brillanz und davon ausgehend zur Erzeugung von Mischfarben hoher Farbintensität führen. Beugungsgitter nach dem bekannten Stand der Technik sind Graben-Steg-Gitter und es ist davon ausgehend eine zweite Aufgabe der Erfindung Masken und Blenden, die gemäss Patentanspruch 1 hergestellt wurden zur Herstellung von Beugungsgittern zu verwenden, die bei Bestrahlung mit Licht eine höhere Farbintensität und reinere Spektralfarben erzeugen. Diese Aufgabe wird mit dem Verwendungsanspruch 5 gelöst.

Die Erfindung wird im Folgenden anhand von Zeichnungen von Ausführungsbeispielen näher erläutert.
- Fig. 1: zeigt eine Prinzipskizze einer Vorrichtung gemäss Erfindung mit zwei Laseranlagen zur direkten Erzeugung von Beugungsgitter-Arrays auf eine Feststkörperoberfläche,
- Fig. 2: zeigt eine Laserstrahl-Intensitätsformung durch eine Masken- und Blendenkombination,
- Fig. 3: zeigt in einem Schnitt eine bevorzugte Blaze-Gitter-Struktur,
- Fig. 4: zeigt eine erste Maske zur Erzeugung der Blaze-Gitter-Struktur von Fig. 3,
- Fig. 5: zeigt eine zweite Maske zur Erzeugung der Blaze-Gitter-Struktur von Fig. 3,
- Fig. 6: zeigt als ein weiteres Beugungsgitter ein Säulen- bzw. Sacklochgitter mit dreieckigen Säulen bzw. Vertiefungsquerschnitten,
- Fig. 7: zeigt ein Beugungsgitter-Array mit den dazugehörigen Farbpixeln und
- Fig. 8: zeigt eine vom menschlichen Auge nicht mehr auflösbare Subfläche, die von einer Anzahl verschiedener Farbpixelflächen gebildet wird.

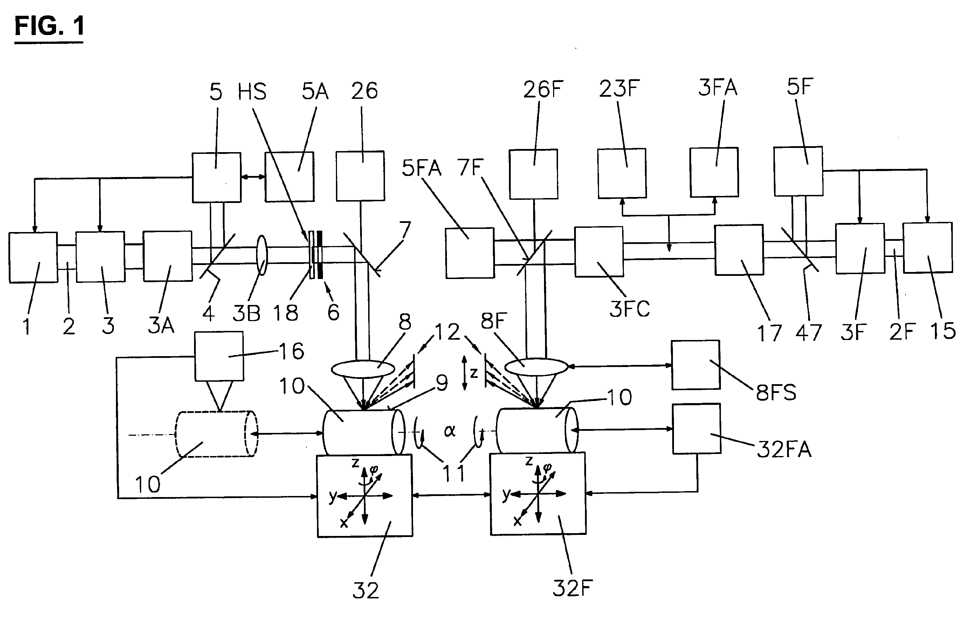

In Fig. 1 ist eine Vorrichtung dargestellt, die sowohl der Herstellung von Masken zur Erzeugung der Gitterstrukturen als auch zur Herstellung von Beugungsgittern mit den hergestellten Masken und Blenden dient. In der Vorrichtung sind zwei Laseranlagen enthalten, wovon die eine, im Bild links, eine Excimerlaser-Anlage darstellt, die für die Herstellung von z.B. Blaze-Gitter-Arrays geeignet ist und die rechte Laseranlage eine Femto- oder Pikosekunden-Laseranlage ist, die einerseits der Herstellung der Masken dient und andererseits in der Lage ist, entweder direkt wirkende Ripples-Gitterstrukturen oder auf der ersten, durch den Excimerlaser erzeugten Gitterstrukturen eine zweite Gitterstruktur zu überlagern, die auf Variation der Abstände zwischen den Ripples beruht.

Mit dem ersten Laser 1, z.B. ein KrF-Excimer-Laser mit einer Wellenlänge von 248 Nanometer (nm), werden mittels Maskenprojektionsverfahren Mikrostrukturen in der Festkörperoberfläche und mit dem zweiten Laser 15, einem Femtosekunden-Laser mit einer mittleren Wellenlänge von 775 nm oder deren frequenzverdoppelten oder -verdreifachten Wellenlänge werden im Fokusverfahren entweder Masken hergestellt oder Nanostrukturen, z.B. Ripples-Gitterstrukturen in der Festkörperoberfläche erzeugt. Unter Festkörper wird im Rahmen dieser Anmeldung jede Unterlage verstanden, in deren Oberfläche mikrostrukturierte Beugungsgitter mittels Laser erzeugt werden können, z.B. Glas, Uhrgläser aus Glas oder Saphir, Keramik, dafür geeignete Kunstoffe und vor allem metallische Oberflächen an Schmuckstücken oder Münzen und insbesondere auch Hartstoffbeschichtete Oberflächen von Prägewerkzeuge wie Prägestempel und Prägeplatten zum Prägen von Verpackungsfolien sowie organischen Festkörpern. Die Oberfläche kann vorgängig vorbehandelt, chemisch oder mechanisch bearbeitet oder strukturiert sein. Als Hartstoff-Beschichtung kommt beispielsweise tetraedisch gebundener amorpher Kohlenstoff (ta-C), Wolframcarbid (WC), Borcarbid (B₄C), Siliciumcarbid (SiC), oder ähnlichen Hartstoffmaterialien in Frage.

Die Mikrostrukturen sind bevorzugt sogenannte Blaze-Gitter mit Gitterperioden von 1 bis 2 *µ*m und die Nanostrukturen können beispielsweise sich selbst organisierende, als optische Beugungsgitter wirkende Ripple-Strukturen mit Perioden von 300 nm bis 1000 nm sein. Wie weiter unten noch erläutert wird ist jede beliebige, periodische Anordnung der beugungsoptisch aktiven Strukturen denkbar, welche bei Bestrahlung mit Licht durch Beugung eine winkelabhängige Dispersion, d.h. eine Zerlegung in Spektralfarben, erzeugt.

In Fig. 1 ist ein erster Laser, ein Excimerlaser 1 dargestellt, dessen Strahl 2 hier einen rechteckigen Querschnitt besitzt. Die Intensität dieses Laserstrahls kann durch einen Abschwächer 3 eingestellt und variiert werden. Mit Hilfe des Homogenisierer 3A und der Feldlinse 3B wird im homogenen Fleck HS eine homogene Intensitätsverteilung über den Laserstrahlquerschnitt erzeugt. Mit Hilfe der Maske 18, die im homogenen Fleck HS positioniert ist, wird aus dieser homogenen Intensitätsverteilung das für die zu erzeugende Mikrostruktur erforderliche Intensitätsprofil über den Laserstrahlquerschnitt geformt.

Die geometrische Form der Öffnung in der Blende 6, die nach der Maske und vorzugsweise in Kontakt mit dieser angeordnet ist, erzeugt die Querschnittsgeometrie, Umrissform, des durch die Maske 18 geformten Intensitätsprofils des Laserstrahls. Maske 18 und Blende 6 befinden sich in einer Masken- und Blendenwechseleinrichtung, die nur schematisch dargestellt ist.

Anstatt eines KrF-Excimerlaser kann als erster Laser 1 ein ArF-Excimerlaser mit 193 nm Wellenlänge, ein Fluor (F₂)-Laser mit 157 nm Wellenlänge oder ein XeCl-Excimerlaser mit 308 nm Wellenlänge eingesetzt werden.

Anstatt eines Femtosekundenlasers kann als zweiter Laser 15 ein Picosekundenlaser des Typs Nd:YAG, mit einer Wellenlänge von 1064 nm oder deren frequenzverdoppelten Wellenlänge von 532 nm oder deren frequenzverdreifachten Wellenlänge von 266 nm eingesetzt werden.

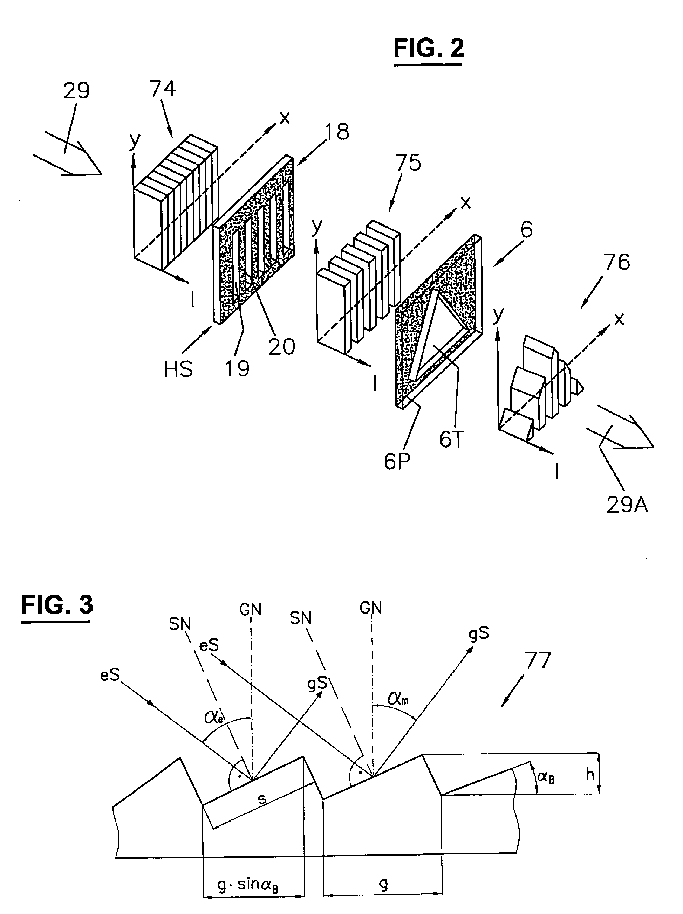

Der durch die Maske 18 und Blende 6 geformte Laserstrahl, siehe auch Fig. 2, fällt auf einen Umlenkspiegel 7, der den Strahl durch eine für diesen Laserstrahl geeignete Abbildungsoptik 8 lenkt, die mit einem vorgegebenen Abbildungsmassstab von z.B. 8:1 das für die Mikrostruktur geeignete Laserintensitätsprofil auf der Oberfläche 9 der ta-C-Schicht auf der Prägewalze 10 abbildet. Durch die Drehpfeile 11 wird angedeutet, dass die Prägewalze 10 um vorgegebene Winkel um ihre Längsachse gedreht werden kann. Die Prägewalze 10 ist auf einer Bewegungseinrichtung 32 angeordnet.

Zur Einstellung, Kontrolle und Konstanthaltung der Leistung und damit der Intensität des Laserstrahls wird mittels des Strahlteilers 4 ein geringer Laserstrahlanteil auf einen Leistungsmesser 5 gerichtet, der Daten zur Steuerung des Abschwächers 3 und/ oder des Lasers 1 liefert. Dieser Leistungsmesser 5 kann wahlweise mit einem Laserstrahl-Intensitätsprofilmessgerät 5A getauscht werden, was in Fig. 1 durch einen Doppelpfeil gekennzeichnet ist. Die Geräte 5 und 5A sind im gleichen Abstand zum Strahlteiler 4 angeordnet wie die sich im homogenen Fleck HS befindende Maske 18, damit die Leistung und die Intensitätsverteilung des Laserstrahls im homogenen Fleck HS, d.h. in der Maskenebene, korrekt gemessen werden kann. Zur Beobachtung des Mikrostrukturierungs-Prozesses dient eine Kamera 26. Der Umlenkspiegel 7 besitzt dazu ein Interferenzschichtsystem, das die Excimerlaserstrahlung mit 248 nm Wellenlänge reflektiert, sichtbares Licht jedoch transmittiert.

Zur Einstellung einer genau vorgegebenen Fokuslage des mit der Abbildungsoptik 8 auf der zu strukturierenden ta-C Schicht abgebildeten Laserstrahls über den gesamten Oberflächenbereich der Prägewalze 10 wird die Lage und die fertigungsbedingte Abweichung der Prägewalze von der Idealgeometrie mit Hilfe des Geräts 16 zur Lagevermessung der Prägewalze vermessen, beispielsweise mittels Triangulations-Messverfahren. Diese Messdaten werden dann zur automatischen Justierung der Prägewalze 10 mit Hilfe der Bewegungseinrichtung 32 und zur Korrektursteuerung der z-Achse der Bewegungseinrichtung 32 während des Strukturierungsprozesses verwendet.

Wie bei der Beschreibung des Ausführungsbeispiels gemäss Fig. 1 bereits kurz erwähnt wurde, wird das für die Excimerlaser-Strukturierung im Maskenprojektionsverfahren erforderliche Intensitätsprofil des Laserstrahls mit Hilfe einer Maske und einer Blende geformt.

Dieser Vorgang soll nachfolgend anhand von Fig. 2 näher erläutert werden: Aus der homogenen Intensitätsverteilung 74 des Laserstrahls 29 im homogenen Fleck HS wird mit Hilfe der im homogene Fleck HS positionierten Maske 18, das für die zu erzeugende Mikrostruktur in der ta-C Schicht auf der Prägewalze 10 erforderliche Intensitätsprofil über den Laserstrahlquerschnitt geformt. Die Maske 18 besitzt in der vorliegenden schematischen Darstellung gitterartig angeordnete transparente Bereiche 19 und für den Laserstrahl opake Flächenbereiche 20 und formt somit ein gitterartiges Intensitätsprofil 75 mit quaderförmigen IntensitätsprofilAnteilen.

Die Blende 6, die in Laserstrahlrichtung nach der Maske und vorzugsweise in Kontakt mit dieser angeordnet ist, erzeugt durch die geometrische Form ihrer Öffnung oder ihres transparenten Flächenbereichs die Querschnittsgeometrie des durch die Maske 18 geformten Intensitätsprofils des Laserstrahls. In der vorliegenden Darstellung ist die Form der Blendenöffnung 6T oder der für den Laserstrahl transparente Flächenbereich der Blende im opaken Teil 6P als Dreieck ausgebildet und das Intensitätsprofil 76 des Laserstrahls 29A besitzt nach der Blende somit eine Dreiecks- Querschnittsgeometrie.

In Fig. 2 wurden die Gitterperiode der Maske 18 und die Dicke und der Abstand der quaderförmigen Intensitätsprofil-Anteile des Laserstrahlintensitätsprofils 75 nach der Maske in x-Koordinatenrichtung stark vergrössert dargestellt, sie betragen konkret bei einem Abbildungsverhältnis des Masken-Projektionssystems von 8:1 beispielsweise nur 8 bis 16 *µ*m, um mit dem mittels der Maske geformten Laserstrahl 29A beispielsweise Gitterstrukturen mit Gitterperioden von 0,5 *µ*m bis 5 *µ*m in der Festkörperoberfläche 9, z. B. eine ta-C-Schicht auf der Prägewalze 10 zu erzeugen. Bei gleicher Flächengrösse des homogenen Flecks HS und des strukturierten Bereichs der Maske 18 von beispielsweise 8 mm x 8 mm = 64 mm² besteht der strukturierte Maskenbereich in Wirklichkeit, abweichend vom Schema gemäss Figur 2, aus einem Streifen-Gitter mit 1000 bis 500 Gitterperioden und der damit geformte Laserstrahl aus 1000 bis 500 quaderförmigen Intensitätsprofilanteilen.

Durch die Grösse, die Form, den Abstand, die Lage und die Anzahl der transparenten Flächenbereiche der Maske 18, nachfolgend als Maskenstruktur bezeichnet, wird das Laserstrahlintensitätsprofil für die Erzeugung der vorgegeben optisch wirkenden Mikrostruktur in der ta-C Schicht und durch die Blende 6 wird die QuerschnittsGeometrie des Laserstrahlintensitätsprofils und damit die geometrische Form des mikrostrukturierten Grundgebiets auf der Prägewalze bestimmt. Als Grundgebiet wird hier die Fläche auf der Prägewalze oder dem Prägestempel bezeichnet, die durch eine Laserstrahlpulsfolge (Pulssequenz) mit dem durch die Maske und Blende geformten und auf der ta-C beschichteten Walzenoberfläche abgebildeten Laserstrahl ohne Relativbewegung zwischen Laserstrahl und Walzenoberfläche strukturiert wird.

Folglich kann durch Veränderung der Maskenstruktur und insbesondere durch Drehen der Maske um vorgegebene Winkel um die optische Achse des Laserstrahls die Ausrichtung des mit der Maske geformten und mittels der Fokussieroptik 8 auf der ta-C Schicht der Prägewalze abgebildeten LaserstrahlIntensitätsprofils und damit die optische Wirkung des mikrostrukturierten Grundgebiets bei Bestrahlung mit polychromatischem Licht variiert werden, beispielsweise die Betrachtungsrichtung und der Betrachtungswinkel sowie die Farbe und Intensität.

Durch Drehen der Blende 6 um vorgegebene Winkel um die optische Achse des Laserstrahls wird die Ausrichtung der durch die Blende geformten Querschnittsgeometrie des mittels der Fokussieroptik auf der ta-C Schicht der Prägewalze abgebildeten Laserstrahls variiert und somit die Ausrichtung des laserstrukturierten Grundgebiets auf der Oberfläche der Prägewalze verändert.

Die mikrostrukturierten Grundgebiete können entweder nach einem bestimmten Muster nebeneinander gesetzt oder nach Drehung der Maske um einen vorgegebenen Winkel von der gleichen Mikrostruktur unter diesem vorgegebenen Winkel überlagert werden. Durch Verwendung verschiedener Masken können auch unterschiedliche Mikrostrukturen in einem Grundgebiet überlagert werden. Beim Nebeneinandersetzen können die Grundgebiete in ihrer Flächenform und ihren Mikrostrukturen jeweils einander gleich oder voneinander verschieden sein.

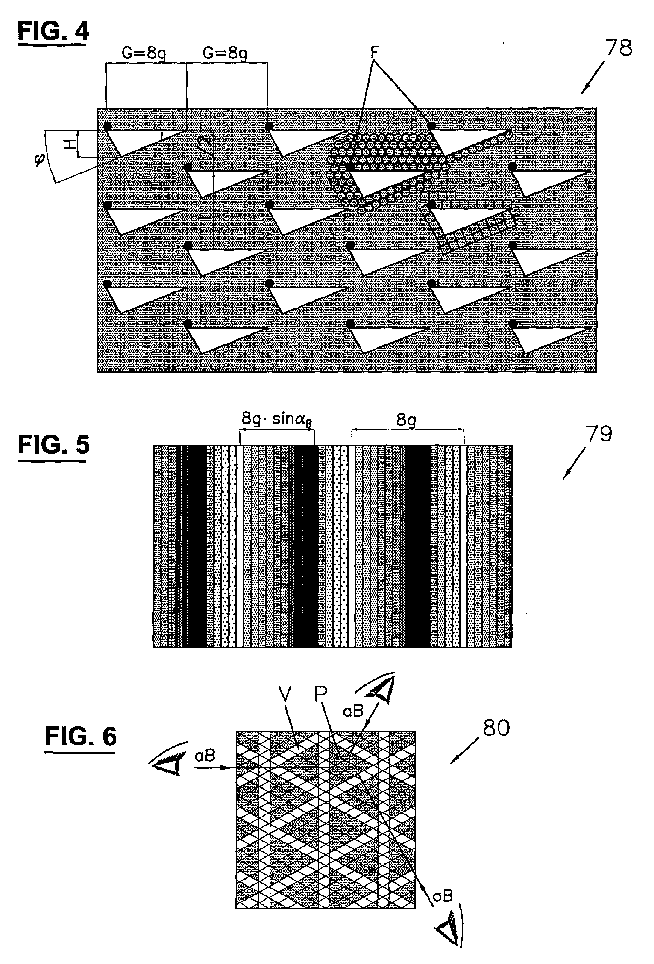

Die Blaze-Gitter-Struktur von Fig. 3 wird mit Hilfe der Maske von Fig. 4 hergestellt, wobei diese Maske aus einem Quarzglassubstrat besteht, dessen opake Oberfläche durch einen Femtosekundenlaser- oder F₂ -Laser-Strahl erzeugt werden kann und die transmittierenden dreieckigen Flächen, die dann bei Bestrahlung durch den vorgenannten Excimerlaser die Blaze-Gitter-Struktur erzeugen, ausgespart werden. Durch die Bestrahlung mit FEmtosekundenlaserpulse oder mit Fluorlaserpulsen wird die Oberfläche des Quarzsubstrats aufgeraut und modifiziert, wodurch das einfallende Licht gestreut, jedoch nicht absorbiert wird. Mit dem Begriff modifiziert wird hier eine Änderung der Materialdichte, der Struktur und der Brechzahl des Substrats bezeichnet.Dadurch wird eine sehr geringe thermische Belastung, eine hohe Maßhaltigkeit und eine sehr hohe Lebensdauer von solchen Masken garantiert.

Bei der Maskenherstellung im Quarzglasmaskensubstrat mit dem Femtosekunden- oder F₂ -Laser im Maskenprojektionsverfahren wird der nicht transparente Bereich, der die transparenten transmittierenden Dreiecksflächen freilässt, durch Abscannen mit einem möglichst geringen Fokusquerschnitt F und Überlappung der Laserpulse erzeugt, in Fig. 4 als graue gefüllte kleine Kreise des fs-Lasers oder schwarz gefüllte kleine Kreise des F₂ -Lasers dargestellt. Die kleinen Quadrate deuten an, dass auch mittels quadratischen Querschnittsformen des Laserstrahls gearbeitet werden kann. Auf diese Weise wird ausser die weiss dargestellten transmittierenden Dreiecksflächen der gesamte, in Fig. 4 grau dargestellte Flächenbereich abgescannt. Die Oberfläche der abgescannten Bereiche wird dabei mit geeigneter Fluenz des Laserstrahls so aufgeraut und modifiziert, dass diese Bereiche die auftreffenden Laserstrahlanteile des Excimerlasers stark streuen und somit für den Laserstrahl als opake Bereiche wirken.

Die Grösse G ist die Basisseite des transmittierenden Dreiecks und ist 8x die Gitterkonstante g, da hier für die Erzeugung des Blazegitters mit Hilfe der Maske mittels des Excimerlaser-Maskenprojektionsverfahrens ein Abbildungsverhältnis von 8:1 verwendet wird. Entsprechend ist H die Höhe und ϕ der Basiswinkel des transmittierenden Dreiecks und I der Abstand der transmittierenden Dreiecke in der Maskenscannrichtung. Falls mit einer F₂ -Laseranlage gearbeitet wird, wird ein anderes Abbildungsverhältnis von 25:1 verwendet.

Blaze-Gitter-Strukturen können auch mit Hilfe von Streifenmasken 79 gemäss Fig. 5 erzeugt werden, wobei die Streifenmaske zwei verschiedene zur Erzeugung einer Blaze-Gitterfurche erforderliche Streifenbreiten mit Transmissionsgrade zwischen 0 und 1 besitzt, die nach vorgegebenen linearen oder stufenförmigen Funktionen über die jeweilige Streifenbreite variieren. Die Angaben 8g und 8g x sin α_{B} ergeben sich aus dem Abbildungsverhältnis von 8:1 bei der Herstellung der Gitterstrukturen mittels des Maskenprojektionsverfahrens.

Es sind eine grosse Anzahl von Variationsmöglichkeiten zur Herstellung von geeigneten Masken denkbar, die mit Hilfe von fs- oder F₂ -Laseranlagen erzeugt werden können. Die ausgewählten Masken werden, zusammen mit geeigneten Blenden, in einer Wechseleinrichtung zur Erzeugung der Blaze-Gitter-Strukturen in der Laseranlage 1, d.h. für einen Excimerlaser im Maskenprojektionsverfahren eingesetzt. Die Blenden können nach demselben Herstellungsverfahren wie die Masken hergestellt werden. Als Substrat für Masken oder Blenden kann Quarzglas (SiO₂), Saphir (A1₂O₃), Kalziumfluorid (CaF₂) oder Magnesiumfluorid (MgF₂) verwendet werden.

Bei der Beugung von Weisslicht, annähernd Sonnenlicht oder bei Bestrahlung mit polychromatischem Licht, z.B. mit Tageslicht-Leuchtstoffröhren oder Glühbirnen, im folgenden kurz "Licht" genannt, an einem Beugungsgitter erfolgt durch den Wellenlängen abhängigen Beugungswinkel, die sog. Beugungswinkel-Dispersion, eine Aufspaltung in die Spektralfarben, deren Photonen eine bestimmte Wellenlänge besitzen, d.h. monochromatisches Licht. Bei Nichtüberlappung von Beugungsordnungen sind deshalb im gebeugten Licht nur diese Spektralfarben zu beobachten.

Mit Hilfe von Beugungsgitter-Arrays werden Mischfarben durch Überlagerung von mehreren Photonenwellenlängen der Spektralfarben erzeugt, die unter einem oder mehreren vorgegebenen Betrachtungswinkeln und einer oder mehreren vorgegebenen azimutalen Betrachtungsrichtungen der Beugungsgitter-Arrays betrachtet werden können. Mit Hilfe von Beugungsgitter-Arrays in einer Festkörperoberfläche, die in den Teilflächen mit Mikroabmessungen = Farbpixelflächen unterhalb des Auflösungsvermögens des menschlichen Auges unterschiedliche Gitterperioden besitzen, werden bei Lichtbestrahlung des Beugungsgitter-Arrays die Mischfarben vorzugsweise aus Photonen der im Beugungsspektrum vorkommenden drei verschiedenen Grundfarbenwellenlängen Rot, Grün und Blau erzeugt, wobei die Wellenlängen für die Grundfarben je nach Anwendungszweck ausgewählt werden. Für die Betrachtung der Mischfarbe mit dem menschlichen Auge sind z.B. für die Grundspektralfarbe Rot eine Wellenlänge λrot von 630 nm, für Grün eine Wellenlänge λgrün von 530 nm und für Blau eine Wellenlänge λblau von 430 nm von Vorteil.

Das Beugungsgitter-Array kann beispielsweise aus Farbpixel-Beugungsgitterflächen für die Erzeugung der Grundfarben Rot, Grün und Blau zusammengesetzt sein, entsprechend den Zapfen-Photorezeptoren des menschlichen Auges, die drei verschiedene Sorten von Sehpigmenten enthalten, die vorwiegend rot-, grün- und blauempfindlich sind. Als Beugungsgitterarten sind vorzugsweise die erfindungsgemässen Blaze-Gitter einsetzbar, die durch Excimer-Laser-Strukturierung im Maskenprojektionsverfahren hergestellt werden

Die Gitterperiode und die Ausrichtung des Beugungsgitters innerhalb der Farbpixelfläche bestimmen bei vorgegebenem Einfallswinkel des Lichts, bzw. bei diffuser Bestrahlung, die Beugungsrichtungen der Spektralfarben und damit den Betrachtungswinkel und die azimutale Betrachtungsrichtung der Grundfarbe des einzelnen Farbpixels. Dabei müssen die unterschiedlichen Gitterperioden für die einzelnen Wellenlängen der Mischfarbe so gewählt und die Beugungsgitter der Arrays so ausgerichtet werden, dass der Beugungswinkel und die Beugungsrichtung wenigstens einer Beugungsordnung für jede Wellenlänge der Mischfarbe gleich sind, um eine effektive Farbmischung wenigstens unter einem Betrachtungswinkel in wenigstens einer azimutalen Betrachtungsrichtung zu erreichen.

In Fig. 3 ist ein mit der Maske von Fig. 4 hergestelltes Blaze-Gitter 77 exemplarisch dargestellt. Beim Glaze-Gitter kann das Maximum der Spaltfunktion und damit das intensivste Intensitätsmaximum vom Maximum der 0-ten Beugungsordnung in ein Maximum höherer Beugungsordnung durch Variation der Neigung der Stufen, d.h. durch Variation des Blaze-Winkels α_{B} verschoben werden, da das Maximum der Spaltfunktion und damit das intensivste Intensitätsmaximum immer in Reflexionsrichtung relativ zur Stufennormalen SN liegt. Bei Variation von α_{B} bleiben die Beugungswinkel αₘ = Betrachtungswinkel der verschiedenen Beugungsordnungen und damit die Lage der Maxima der Gitterbeugung unverändert, wenn die Gitterperiode g und der Einfallswinkel αₑ des auftreffenden Lichts konstant gehalten werden. Ausserdem bezeichnet in Fig. 3 s die Blazegitter-Seite, h die Blazegitter-Höhe, eS den einfallenden Strahl, GN die Gitternormale und SN die Stufennormale.

Da nahezu die gesamte Gitterfläche, genauer die Fläche gebildet aus Stufenbreite s multipliziert mit der Gitterfurchenlänge und der Anzahl Furchen für die Beugung genutzt wird, sind die Beugungsintensitäten und damit die beobachtete Brillanz der gebeugten Spektralfarben am Blazegitter wesentlich grösser als bei der Beugung an einem einfachen Strichgitter = Graben-Steg-Gitter.

Mit dem Femtosekunden-Laser können auch sich selbst organisierende Ripples erzeugt werden, die in einer Gitterstruktur angeordnet sind mit denen Spektralfarben erzeugt werden können, die mischbar sind. Diese Gitterstrukturen können den Blaze-Gitterstrukturen überlagert werden. Zur einstellbaren Herstellung von verschiedenen Ripples-Abständen, die die gewünschten Gitterkonstanten ergeben, wird die Substratebene während der Ripples-Erzeugung in Bezug auf den Laserstrahl um einen bestimmten Winkel geneigt.

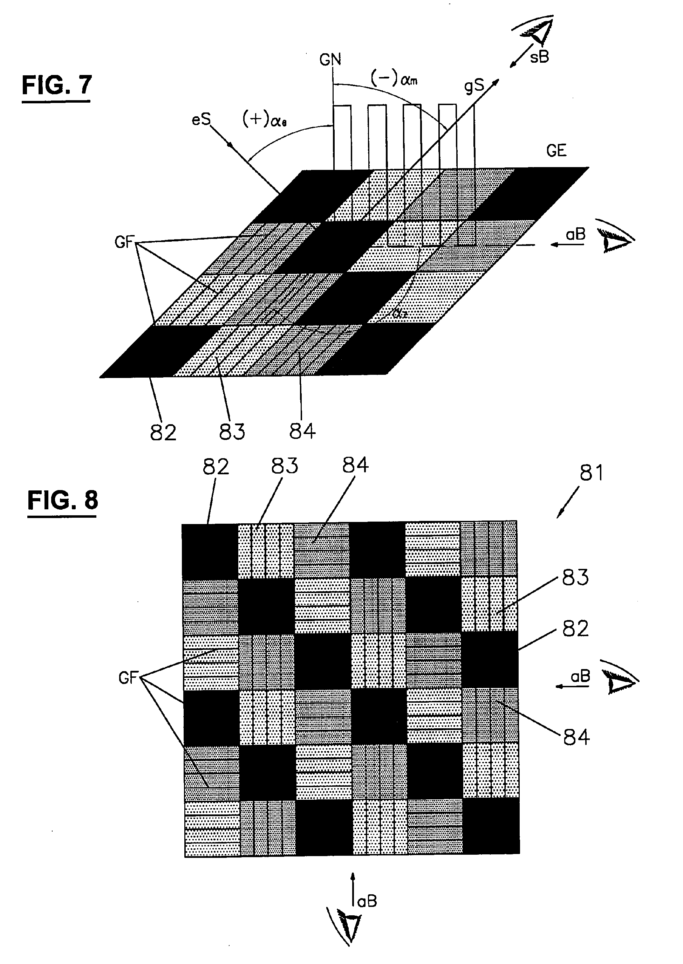

Da wie bereits gesagt das Auge 200 µm gerade noch auflösen kann, muss die maximale Seitenlänge eines quadratischen Farbpixels kleiner als 200 µm durch drei = 66,67 µm sein. Zur Erzeugung einer Mischfarbe enthält eine Subfläche von 200 µm x 200 µm dann mindestens 9 quadratische Farbpixel für die Grundfarben Rot, Grün und Blau, wobei jedes Farbpixel definitionsgemäss eine einzige Spektralfarbe als Grundfarbe enthält. Mit einer Seitenlänge eines Farbpixels von 33,33 µm enthält eine Subfläche 81 gemäss Fig. 8 dann insgesamt 36 quadratische Farbpixel 82, 83, 84 für die Grundfarben Rot, Grün und Blau.

Diese Grössenverhältnisse ermöglichen eine neue Klasse von Authentifizierungsmerkmalen, indem z.B. in einer Subfläche ein oder nur wenige andersfarbige Farbpixel eingestreut werden, die von Auge nicht sichtbar, aber mittels einem angepassten Spektrometer entdeckbar sind.

Im Nachfolgenden wird ein Berechnungsbeispiel für eine Gitterstruktur gemäss der Subfläche 81 von Fig. 8 gegeben. Bei einer Seitenlänge eines quadratischen Farbpixels von 33,33 µm, senkrechtem Lichteinfall und einem Beugungswinkel = Betrachtungswinkel αₘ für Rot, Grün und Blau von 30° mit den berechneten Werten für die Gitterperioden von g_{Rot} = 1,26 µm, g_{Grüm} = 1,06 µm, g_{Blau} = 0,86 µm, enthält das rote Pixelquadrat 29 Gitterperioden, das grüne Pixelquadrat 38 Gitterperioden und das blaue Pixelquadrat 47 Gitterperioden.

Die Beugungsintensität eines Farbpixels ist eine Funktion der Anzahl der Gitterperioden, d.h. der Gesamtgitterfurchen-Länge innerhalb des Farbpixels und der Wellenlänge der Grundfarbe. Die Intensitätsteuerung kann nur über die Flächengrösse bzw. Anzahl der einzelnen Grundfarbenpixel erfolgen. Dazu müssen unterschiedliche Faktoren berücksichtig werden, wie die Lichtquelle, d.h. z.B. Sonnenlicht am Tag, am Morgen und am Abend, Tageslicht-Leuchtstoffröhre, Glühbirne und dergl., die einen verschiedenen Intensitätsverlauf über den emitierten Wellenlängenbereich besitzen und somit die Intensität der einzelnen Spektral-Farben beeinflussen. Ausserdem muss das menschliche Auge bzw. dessen spektrale Hellempfindlichkeit für die gewählten Wellenlängen der Grundfarben mitberücksichtigt werden.

Nach Berechnungen gemäss der Normfarbtafel nach DIN 5033 wird beispielsweise die Farbe Weiss aus den durch Gitterbeugung in eine Betrachtungsrichtung ausgewählten obig angegebenen Spektralfarben Rot, Grün und Blau mit folgender Pixelaufteilung erhalten, wenn eine Subfläche von 200 µm x 200 µm aus 36 Farbpixeln mit 33,33 µm x 33,33 µm Pixelfläche zusammengesetzt ist: 14 rote Farbpixel 82, 10 grüne Farbpixel 83 und 12 blaue Farbpixel 84. Die Farbe Rosa wird nach den gleichen Berechnungen mit folgender Pixelaufteilung erhalten: 22 rote Pixel 82, 3 grüne Pixel 83 und 11 blaue Pixel 84. Die Hautfarbe wird nach gleicher Berechnung mit folgender Pixelaufteilung erhalten: 21 rote Pixel 82, 7 grüne Pixel 83 und 8 blaue Pixel 84.

Der Hinweis auf das Auflösungsvermögen des menschlichen Auges bedeutet nicht, dass die erzeugten Spektral- und Mischfarben nicht auch maschinell gelesen und ausgewertet werden können. Insbesondere bei Authentifizierungsmerkmalen, die in der Regel so klein als möglich sein sollten, ist das maschinelle Lesen besonders sinnvoll.

Die Gitterperiode und die Ausrichtung des Beugungsgitters innerhalb der Farbpixelfläche bestimmen bei vorgegebenem Einfallswinkel des Lichts die Beugungsrichtungen der Spektralfarben und damit den Betrachtungswinkel und die azimutale Betrachtungsrichtung der Grundfarbe des einzelnen Pixels. Dabei müssen die unterschiedlichen Gitterperioden für die einzelnen Wellenlängen der Mischfarbe so gewählt und die Beugungsgitter der Arrays so ausgerichtet werden, dass der Beugungswinkel und die Beugungsrichtung wenigstens einer Beugungsordnung für jede Wellenlänge der Mischfarbe gleich sind, um eine effektive Farbmischung wenigstens unter einem Betrachtungswinkel in wenigstens einer azimutalen Betrachtungsrichtung zu erreichen.

Gemäss Fig. 3 ist beim Blaze-Gitter 77 α_{B} der Neigungswinkel der beugenden Gitterfurchen (Blaze-Winkel) und der Beugungswinkel αₘ der Winkel zwischen der Gitternormalen GN und der Beugungsrichtung des Intensitätsmaximums des gebeugten monochromatischen Strahlanteils gs der jeweiligen Beugungsordnung z und gibt bei vorgegebenen Einfallswinkel αₑ des einfallenden Lichts somit den Betrachtungswinkel αₘ und die Betrachtungsrichtung gS für diesen Strahlanteil an. Der Beugungswinkel αₘ wird durch die Wellenlänge des einfallenden Lichts, den Einfallswinkel αₑ und die Gitterperiode g bestimmt. Solche Blaze-Gitter für beugungsoptische Anwendungen weisen in der Regel Gitterperioden g von 0,5 *µ*m bis 5 *µ*m auf.

Als azimutale Betrachtungsrichtung aB des gebeugten monochromatischen Strahlanteils wird die von der Gitternormalen GN ausgehende Richtung der Schnittlinie der von der Gitternormalen und der Beugungsrichtung gS aufgespannten Ebene mit der Gitterebene GE bezeichnet, die vom Azimutwinkel α_{z} gekennzeichnet ist, siehe auch Fig. 7. In Fig. 7 bezeichnet sB die Betrachtungsrichtung auf den gebeugten Strahl.

Ausserdem ist der Betrachtungswinkel für die Mischfarbe somit von den aufeinander abgestimmten Gitterperioden der verschiedenen Farbpixelarten abhängig und die Betrachtungsrichtung wird von der Ausrichtung der Gitterstrukturen, der Gitterfurchen GF in den verschiedenen Farbpixelflächen, die zur Erzeugung der Mischfarbe erforderlich sind, bestimmt. Die Erzeugung einer Mischfarbe muss innerhalb einer von menschlichem Auge nicht mehr auflösbaren Subfläche von höchstens 200 µm x 200 µm erfolgen, die von einer genügend grossen Zahl von verschiedenen Farbpixelflächen gebildet wird.

Mehrere Betrachtungsrichtungen lassen sich realisieren, wenn die Gitterfurchen GF in den Farbpixeln mehrere azimutale Ausrichtungen aufweisen: Wenn beispielsweise die Gitterstrukturen in einer Hälfte der in der Subfläche enthaltenen Pixel einer Grundfarbe senkrecht zu den Gitterstrukturen in der anderen Hälfte der Pixel ausgerichtet sind, existieren insbesondere bei diffuser Weisslichtbestrahlung des Gitters auch zwei azimutale Betrachtungs-Richtungen aB senkrecht zueinander, siehe Fig. 8. Dazu muss jedoch die Hälfte der Gesamtzahl der Farbpixel in der Subfläche für die Erzeugung der Mischfarbe ausreichen. Die Mischfarbe wird dann aber in jeder der zwei azimutalen Betrachtungs-Richtungen mit geringerer Intensität wahrgenommen.

Auf diese Weise können auch drei azimutale Betrachtungs-Richtungen, die sich z.B. um 120° unterscheiden, realisiert werden. Gemäss Fig. 6 können mit Hilfe eines Säulenrastergitters 80, d.h. als Säulen P ausgebildete Erhebungen oder komplementäre Vertiefungen verschiedener Querschnittsformen, z.B. Kreis, Dreieck, Viereck, Sechseck und Abmessungen mehrere azimutale Betrachtungsrichtungen realisiert werden. Z.B. ergibt ein dreieckiger Säulen- oder Vertiefungsquerschnitt drei um 2/3 π = 120° versetzte azimutale Betrachtungs-Richtungen aB.

Wenn unterschiedliche Pixelgrössen für die Grundfarben gewählt werden, dann müssen die Seitenlängen der grösseren Pixel ein ganzzahliges Vielfaches der Seitenlänge des kleinsten Pixels betragen, damit die Subfläche zum Erreichen der maximal möglichen Mischfarbenintensität vollständig mit Farbpixeln gefüllt werden kann. Eine Verringerung der Intensität, Abdunkelung, ist durch Einfügen von Pixelflächen in die Subfläche erreichbar, die z.B. bei ta-C Schicht-Substraten nicht strukturiert sind oder die Lichtwellenlängen absorbierende oder in eine andere Richtung beugende Gitterstrukturen besitzen.

Zur Intensitätssteuerung der Grundfarben für die Mischfarbenerzeugung können neben der Zahl und der Flächengrösse der Farbpixel sowie der Wahl der Beugungsordnung der Pixel in die Betrachtungsrichtung auch verschiedene Beugungsgitterarten in den Pixeln der Grundfarben einer Subfläche genutzt werden, da z.B. Blaze-Gitter höhere Intensitäten als Graben-Steg-Gitter liefern.

Die Beugungsgitter-Arrays werden in Oberflächen von Festkörpern wie z.B. Metalle, metallische Legierungen, Gläser, Kunststoffe mit harten Oberflächen sowie von ta-C-Schichten oder andere Hartstoffmaterialien wie z.B. Hartmetalle, Karbide wie Wolframkarbid und Borkarbid eingebracht. Dabei können Beugungsgitter-Arrays in verschleissfesten Hartstoffmaterialien, z.B. auf Prägewerkzeuge zum Prägen von Farbmustern, Authentifizierungsmerkmalen oder farbig wirkenden Zeichen auf Verpackungsfolien aufgebracht werden, wobei es ersichtlich ist, dass das Negativ der Beugungsgitter-Strukturen auf dem Prägewerkzeug in seiner QuerschnittsGeometrie und den Abmessungen der Mikrostrukturen derart gestaltet sein muss, dass unter Berücksichtigung der Eigenschaften des zu prägenden Materials und der Prägeparameter das geprägte Positiv das für die beabsichtigte beugungsoptische Wirkung optimale Beugungsgittermuster darstellt, das als Farbmuster wahrnehmbar ist.

Definitionsgemäss umfasst der Begriff "Farbmuster" alle Arten von Veränderungen einer Oberfläche, die eine Farbe hervorrufen, insbesondere auch im menschlichen Auge, wobei es sich in der Regel, aber nicht ausschliesslich, um Mischfarben handelt, die durch Reflexion an entsprechenden Beugungsgittern entstehen.

Die Laseranlage 1 mit einer Wechseleinrichtung für Blenden und Masken, die es ermöglicht, eine beliebige Maske und eine beliebige Blende in den Strahlengang des Excimerlasers zu bringen, erlaubt eine grosse Vielfalt nicht nur von verschiedenen Gitterstrukturen mit verschiedenen Gitterkonstanten sondern auch eine Vielfalt von Gestaltungsmöglichkeiten der äusseren Umrisse der Gitterstrukturflächen. So ist es möglich, die Flächenformen der strukturierten Grundgebiete, die aus einer Vielzahl von Subflächen zusammengesetzt sind, als Quadrate, Rechtecke, Dreiecke, Parallelogramme, Sechsecke usw. oder gegebenenfalls als Kreise auszubilden, wobei in diesen Grundgebieten die verschiedensten Gitterstrukturen zur Erzeugung von Farben und Mischfarben vorhanden sein können. In gewissen Anordnungen ist es auch möglich, beispielsweise aus drei Parallelogrammen bestehende dreidimensional wirkende Würfelmuster oder mehrstrahlige Sterne, usw. zu gestalten.

Die beiden Laseranlagen ermöglichen es ausserdem, verschiedenste Gitterstrukturen übereinander zu lagern, z.B. zuerst eine gewisse Gitterstruktur und nach Muster angeordnete Grundgebiete mittels des Excimerlasers zu erzeugen über die mittels des Femtosekunden-Lasers Ripple-Gitter-Strukturen gelegt werden, um eine weitere Kombination von Farben und Mischfarben zu erzeugen, die insbesondere auch als Authentifizierungsmerkmale verwendet werden können. Dabei können verschiedene Betrachtungswinkel realisiert werden oder stufenweise oder kontinuierliche Farbenwechsel oder Erscheinen und Verschwinden von Farbmustern oder Farbbildern bei Neigen bzw. Drehen des Beugungsgittermusters durch stufenweise Änderung der Gitterperioden oder der Ausrichtung der Gitterfurchen.

Die Farben, bzw. die Mischfarben, können als Muster, Zeichen, Logos oder bei spezifischen Anwendungen als Authentifizierungsmerkmale erscheinen. Es sind eine Anzahl Anwendungsbereiche bekannt, bei denen optische Merkmale verwendet werden, die einerseits hohen ästhetischen Anforderungen genügen müssen und andererseits der Authentifizierung von Waren dienen. Eine solche Gruppe von Anwendungen sind beispielsweise Verpackungsfolien für Zigaretten, Nahrungsmittel oder Medikamente, wobei diese Folien in der Regel durch Prägewalzen geprägt werden oder es kann sich um die Oberfläche eines Schmuckgegenstandes, z. B. ein Uhrengehäuseteil oder eine Münze handeln. Insbesondere bei Verpackungsfolien können farbige Muster zunehmend an Bedeutung erlangen, falls die Metallisierungsschicht noch dünner wird oder ganz entfällt. Bei den Prägewerkzeugen oder Schmuckgegenständen wird eine Metalloberfläche strukturiert, die im Falle von Prägewerkzeugen eine Hartstoffschicht ist. Dies ist zum Beispiel in der WO 2007/012215 A1 desselben Anmelders offenbart.

## Patentansprüche

1. Verfahren zur Herstellung von Masken und/oder Blenden für eine Laseranlage zur Erzeugung von Mikrostrukturen auf einer Festkörperoberfläche, wobei die für die Laserstrahlung opaken Bereiche der Masken und/oder Blenden die auffallende Laserstrahlung streuen, **dadurch gekennzeichnet, dass** die die Laserstrahlung streuenden Bereiche durch Bestrahlung mittels eines Femtosekunden-, Pikosekunden- oder Fluorlaserstrahls aufgeraut und modifiziert werden.

2. Verfahren nach Anspruch 1, **dadurch gekennzeichnet, dass** das Substrat Quarzglas (SiO₂), Saphir (A1₂O₃), Kalziumfluorid (CaF₂) oder Magnesiumfluorid (MgF₂) ist.

3. Verfahren nach Anspruch 1 oder 2, **dadurch gekennzeichnet, dass** der Femtosekundenlaser eine mittlere Wellenlänge von 775 nm oder deren frequenzverdoppelte oder frequenzverdreifachte Wellenlänge und der Fluorlaser eine Wellenlänge von 157 nm aufweisen.

4. Verfahren nach einem der Ansprüche 1 bis 3, **dadurch gekennzeichnet, dass** eine Maske (78) mit einer Anzahl von transparenten Dreiecken oder eine Maske (79) mit einer Anzahl von Streifen mit stufenweiser Transparenz hergestellt wird.

5. Verwendung von nach dem Verfahren der Ansprüche 1 bis 4 hergestellten Masken und Blenden zur Erzeugung einer Mikrostruktur auf einer Festkörperoberfläche, wobei mindestens eine Maske mit mindestens einer Blende in einer Wechseleinrichtung angeordnet sind und sich die mindestens eine Maske im homogenen Fleck (HS) einer Maskenprojektions-Einheit einer Excimerlaseranlage befindet und der Herstellung von Blaze-Gitter (77) dient.

6. Verwendung nach Anspruch 5, **dadurch gekennzeichnet, dass** die Blaze-Gitter (77) in Beugungsgitter-Arrays angeordnet sind, wobei die Gitterperioden g der Blaze-Gitter 0,5 µm bis 5 µm betragen und die Blaze-Gitter linear oder kreisförmig ausgebildet sind.

7. Verwendung nach Anspruch 5 oder 6, **dadurch gekennzeichnet, dass** jedes Beugungsgitter-Array aus Subflächen besteht, deren Längeneausdehnung einen Wert unterhalb des Auflösungsvermögens des menschlichen Auges aufweist und die mindestens ein Pixel enthält, wobei ein Pixel eine begrenzte Beugungsgitterstruktur zur Erzeugung einer einzigen Spektralfarbe ist.

8. Verwendung nach Anspruch 7, **dadurch gekennzeichnet, dass** jede Subfläche mindestens zwei Pixel mit je einer voneinander verschiedenen Gitterkonstanten zur Erzeugung von zwei verschiedenen Spektralfarben enthält.

9. Verwendung nach Anspruch 8, **dadurch gekennzeichnet, dass** die Pixelfläche und/oder die Anzahl der Pixel derart gewählt wird, dass sich die verschiedenen Spektralfarben in wenigstens einer vorgebenen Betrachtungsrichtung zu einer Mischfarbe überlagern.

10. Verwendung nach Anspruch 8 oder 9, **dadurch gekennzeichnet, dass** die Wellenlängen für die Grundspektralfarben Rot, Grün und Blau je nach Anwendungszweck ausgewählt werden und dass für die Betrachtung der Mischfarbe mit dem menschlichen Auge die drei Farben Rot, Grün und Blau mit einer Wellenlänge λrot von 630 nm, λgrün von 530 nm und λblau von 430 nm sind.

11. Verwendung nach einem der Ansprüche 7 bis 10, **dadurch gekennzeichnet, dass** die Subflächen eine maximale Längenausdehnung von 200 µm und die zugehörigen Pixelflächen eine maximale Längenausdehnung von 66,67 µm aufweisen.

12. Verwendung nach einem der Ansprüche 7 bis 11, **dadurch gekennzeichnet, dass** mehrere Subflächen zu Zeichen, Bilder, Logos, oder Authentifizierungsmerkmale aneinandergereiht auf eine Festkörperoberfläche aufgebracht werden.

13. Verwendung nach Anspruch 12, **dadurch gekennzeichnet, dass** die Festkörperoberfläche eine hartstoffbeschichtete Oberfläche einer Prägewalze oder eines Prägestempels zum Prägen von Verpackungsfolien ist, wobei die Hartstoff-Beschichtung aus ta-C, Wolframcarbid (WC), Borcarbid (B₄C), Siliciumcarbid (SiC), oder ähnlichen Hartstoffmaterialien besteht.

14. Vorrichtung zur Durchführung des Verfahrens nach einem der Ansprüche 1 bis 13, **dadurch gekennzeichnet, dass** der erste Laser (1) ein KrF-Excimerlaser mit einer Wellenlänge von 248 nm, oder ein ArF-Excimerlaser mit 193 nm Wellenlänge, oder ein Fluor-Laser mit 157 nm Wellenlänge, oder ein XeCl-Excimerlaser mit 308 nm Wellenlänge ist und der zweite Laser zur Erzeugung der Ripples-Strukturen ein Femtosekundenlaser (15) mit einer mittleren Wellenlänge von 775 nm oder deren frequenzverdoppelten oder -verdreifachten Wellenlänge oder ein Picosekundenlaser des Typs Nd:YAG, mit einer Wellenlänge von 1064 nm oder deren frequenzverdoppelten oder -verdreifachten Wellenlänge ist.

15. Vorrichtung nach Anspruch 14, **dadurch gekennzeichnet, dass** zwischen dem ersten Laser (1) und seiner Abbildungsoptik (8) mindestens eine Masken- und Blendenkombination (18, 6) angeordnet ist, wobei eine Anzahl von Masken- und Blendenkombinationen in einer Wechseleinrichtung angeordnet ist und die Wechseleinrichtung ausgebildet ist, sowohl einer der Masken (18) als auch eine der Blenden (6) jeweils unabhängig voneinander in den Strahlengang (29) des Lasers (1) zu bringen, wobei die Masken (18) und Blenden (6) linear oder rotativ verschiebbar sowie um sich selbst drehbar in Halterungen angeordnet sind.

16. Vorrichtung nach Anspruch 15, **dadurch gekennzeichnet, dass** die Maske (6) eine Dreiecksmaske (78) oder eine Streifenmaske (79) zur Erzeugung von Blaze-Gittern ist.

17. Vorrichtung nach einem der Ansprüche 14 bis 16, zur Strukturierung von Bereichen einer Prägewalze oder eines Prägestempels zum Prägen von beugungsoptisch wirkenden Bereichen auf einer Verpackungsfolie.

18. Vorrichtung nach einem der Ansprüche 14 bis 16, zur Herstellung von beugungsoptisch wirkenden Zeichen oder Authentifizierungsmerkmalen auf Bereichen von beschichteten und unbeschichteten Uhrenteilen, Uhrgläser aus Glas oder Saphir, Münzen oder Schmuckgegenständen.

19. Verpackungsfolie, die mit den gemäss Anspruch 17 strukturierten Walzen oder Prägestempel geprägt wurde, **dadurch gekennzeichnet, dass** sie beugungsoptisch wirkende Bereiche und/oder Authentifizierungsmerkmale aufweist, die Farbpixel einer Spektralfarbe oder verschiedenfarbige Farbpixel zur Erzeugung von Mischfarben enthalten.

20. Verpackungsfolie nach Anspruch 19, **dadurch gekennzeichnet, dass** sie dort, wo sie keine beugungsoptisch wirkende Bereiche, Authentifizierungsmerkmale und/oder Logos enthält, satiniert ist.
